# EUROPEAN PATENT SPECIFICATION

(11) **EP 1 058 358 B1**
(45) Date of publication and mention of the grant of the patent: **29.10.2008**
(21) Application number: 00870105.4
(22) Date of filing: 15.05.2000
(51) Int. Cl.: H01S 5/026, H01S 5/12, H01S 5/0625

(54) **Tunable integrated semiconductor laser apparatus**
Wellenlängenabstimmbare integrierte Halbleiterlaser-Vorrichtung
Dispositif à laser semi-conducteur intégré accordable en longeur d'onde étendue

(30) Priority: 17.05.1999 EP 99870105; 18.10.1999 EP 99870214
(43) Date of publication of application: 06.12.2000
(73) Proprietor: Interuniversitair Micro-Elektronica Centrum, 3001 Heverlee (BE); Universiteit Gent, 9000 Gent (BE)
(72) Inventor: Sarlet, Gert, 8000 Brugge (BE); Buus, Jens, Gayton Northants NN7 3EZ (GB); Baets, Roel, 9800 Deinze (BE)
(74) Representative: Van Malderen, Joëlle

(56) References cited:
- EP-A- 0 926 787
- US-A- 5 325 392
- US-A- 5 398 256
- US-A- 5 651 018
- WOLF T ET AL: "LASER DIODES AND INTEGRATED OPTOEPELECTRONIC CIRCUITS FOR FIBER OPTICAL APPLICATIONS" EUROPEAN TRANSACTIONS ON TELECOMMUNICATIONS AND RELATED TECHNOLOGIES,IT,AEI, MILANO, vol. 4, no. 6, 1 November 1993 (1993-11-01), pages 599-614, XP000433717 ISSN: 1120-3862
- PATENT ABSTRACTS OF JAPAN vol. 013, no. 026 (E-706), 20 January 1989 (1989-01-20) & JP 63 229796 A (FUJITSU LTD), 26 September 1988 (1988-09-26)
- TALNEAU A ET AL: "CONSTANT OUTPUT POWER AND LOW LINEWIDTH INA SIMPLE WIDE-TUNING DFB LASER WITH MULTIWAVELENGTH GRATING" IEEE JOURNAL OF SELECTED TOPICS IN QUANTUM ELECTRONICS,US,IEEE SERVICE CENTER, vol. 3, no. 2, 1 April 1997 (1997-04-01), pages 628-631, XP000735963 ISSN: 1077-260X
- KUYNETSOV M: "DESIGN OF WIDELY TUNABLE SEMICONDUCTOR THREE-BRANCH LASERS" JOURNAL OF LIGHTWAVE TECHNOLOGY,US,IEEE. NEW YORK, vol. 12, no. 12, 1 December 1994 (1994-12-01), pages 2100-2106, XP000493715 ISSN: 0733-8724

## Description

### Field of the invention

The invention relates to multi-section integrated semiconducting devices or lasers, comprising resonator sections, being either distributed reflection or transmission sections. The invention also relates to methods for widely wavelength tuning semiconductor devices or lasers.

### Background of the invention

Tuning of a conventional Distributed Bragg Reflector (DBR) semiconductor laser is limited by the fact that the relative tuning range is restricted to the relative change in the refractive index of the tuning region. This means that the tuning range, under normal operating conditions, cannot exceed 10 nm. This is substantially less than the potential bandwidth, restricted by the width of the gain curve, which is about 100 nm. Such conventional DBR lasers can functionally be characterized as comprising a first part being a two-sided active section, for creating radiation, for instance a light beam, by spontaneous emission over a bandwidth around one center frequency. Said first part also guides said radiation or light beam. Such conventional DBR lasers further have two reflectors. Said reflectors are bounding said two-sided active section, thus one at each side.

The limited selectivity problem has been recognized by Wolf, et al (European Transactions on Telecommunications and Related Technologies, 4 (1993), No. 6) showing in Fig. 10 a laser structure with two parallel waveguides but without gratings. These two parallel waveguides cannot be considered as resonators, indeed the spectra (shown in Fig. lOb and c) show the comb mode spectra corresponding to arms B and A, but they are either the comb mode spectra of arm B, the gain section and the reflectors R or the comb mode spectra of arm A, the gain section and the reflectors R. As the spacing between the spectral lines are determined by the length of the structures, it appears that said spacing is still very small, resulting in still a low selectivity and a low tuneability.

Over the past years several advanced laser structures have been proposed with an extended tuning range. Examples are the Y-laser [M. Kuznetsov, P. Verlangieri, A.G. Dentai, C.H. Joyner, and C.A. Burrus, "Design of widely tunable semiconductor three-branch lasers," J. Lightwave Technol., vol. 12, no. 12, pp. 2100-2106, 1994], the co-directionally coupled twin-guide laser [M.-C. Amann, and S. Illek, "Tunable laser diodes utilizing transverse tuning scheme," J. Lightwave Technol., vol. 11, no. 7, pp. 1168-1182, 1993], the Sampled Grating (SG) DBR laser [V. Jayaraman, Z.M. Chuang, and L.A. Coldren, "Theory, design and performance of extended tuning range semiconductor lasers with sampled gratings," IEEE J. Quantum Electron., vol. 29, no. 6, pp. 1824-1834, 1993], the Super Structure Grating (SSG) DBR laser [H. Ishii, H. Tanobe, F. Kano, Y. Tohmori, Y. Kondo, and Y. Yoshikuni, "Quasicontinuous wavelength tuning in super-structure-grating (SSG) DBR lasers," IEEE J. Quantum Electron., vol. 32, no. 3, pp. 433-440, 1996] and the Grating assisted Coupler with rear Sampled Reflector (GCSR) laser [M. Öberg, S. Nilsson, K. Streubel, L. Bäckbom, and T. Klinga, "74 nm wavelength tuning range of an InGaAsP/InP vertical grating assisted codirectional coupler laser with rear sampled grating reflector," IEEE Photon. Technol. Lett., vol. 5, no. 7, pp. 735-738, 1993]. In the first two types of devices, a trade-off had to be made between the tuning range and the spectral purity (broad tuning range vs. high Side Mode Suppression Ratio (SMSR)). Therefore recently most research attention has gone to the (S)SG-DBR and GCSR lasers.

A sampled grating DBR laser, comprises of two sampled gratings exhibiting a comb-shaped reflectance spectrum, with slightly different peak spacing due to the different sampling periods. As an alternative, other grating shapes can be used: these are normally referred to as "super structure gratings" (SSG). Lasers of this type have been fabricated with tuning ranges up to about 100 nm. The operation of the device is such that through current injection in the two DBR sections, a peak of the front and rear reflectance comb are aligned at the desired wavelength. The phase section is used to align a longitudinal cavity mode with the peaks of the two reflectors. The disadvantage of the (S)SG-DBR approach is that light coupled out of the laser has to pass a long passive or inactive section, leading to loss. Also, the losses in the two reflector sections increase with the amount of current injected into those sections, leading to a tuning current dependent output power.

The SG-DBR laser and the SSG-DBR laser are functionally characterized as comprising a two-sided active region for light creation and two reflectors one at each side of the active region, said reflectors having a reflection characteristic with a plurality of reflection peaks. Said characteristic has spaced reflection maxima points providing a maximum reflection of an associated wavelength. Such a characteristic can be obtained via sampled gratings, which exhibit a comb-shaped reflection spectrum or via the so-called supergratings. Said gratings or supergratings can also be characterized as distributed reflectors.

Sampled gratings can be described as structures in a waveguide system, having a periodically broken short-period structure including short period stripped regions alternating with non-stripped regions. The supergratings can be described as structures in a waveguide system having a diffractive grating having a plurality of repeating unit regions, each having a constant length, thus forming a modulation period, and at least one parameter that determines the optical reflectivity of said diffractive grating varying depending on its position in each of said repeating unit regions along a direction of optical transmission in said laser, said diffractive grating extending by at least two modulation periods. Reference is made to US patent US5,325,392 related to distributed reflector and wavelength tunable semiconductor lasers, hereby incorporated by reference.

The SG-DBR laser and the SSG-DBR laser are exploiting constructive interference of the periodic characteristics of reflectors, located at different sides of the active section, with different periodicity, to obtain a wide tunability. The alignment of the reflector peaks can be described by stating that the spacing of said reflective maxima points of the reflectors are different or are essentially not equal and only one said reflective maxima of each of said reflectors is in correspondence with a wavelength of said created lightbeam. Reference is made to patent US-A-4,896,325, related to multi-section tunable lasers with differing multi-element mirrors, hereby incorporated by reference.

As the construction of said reflectors leads to long inactive sections, this results in lasing output power losses.

Other lasers, which use a co-directional coupler, readily have a very wide tuning range, but there is insufficient suppression of neighbouring longitudinal modes. The combination of a widely tuneable but poorly selective co-directional coupler with a single (S)SG reflector will give both wide tuning and a good side mode suppression. Furthermore, the optical output signal does not pass through a passive region. Again tuning of 100 nm has been achieved. Unfortunately, such a structure is rather complicated to manufacture, requiring at least 5 growth steps. Reference is made to patent US-A-5,621,828 related to integrated tunable filters, hereby incorporated by reference.

EP-A-0926787 describes a series of strongly complex coupled DFB lasers. In the disclosed structure gratings are made within the active sections. Said gratings are selected such that no substantial interaction between the lasers, defined by a grated active section, in series is obtained. The disclosed structure enables generation of multiple wavelengths, even sumultaneously, but does not address the issue of selectivity and tuneability.

A parallel structure with a plurality of waveguides is disclosed in the PATENT ABSTRACT OF JAPAN, vol. 013, no. 026, 20 January 1989, JP 63 229796 (Fujitsu Ltd. The disclosed structure again enables radiation of a plurality of wavelengths but does not address the issue of tuneability. The optical switch is operated for selecting a waveguide, thus no simultaneously optical connection between said waveguide is obtained.

### Aim of the invention

The aim of the present invention is to disclose laser structures which are easy to manufacture and which are widely tuneable and have low lasing output power losses.

### Summary of the invention

The invention is defined in claims 1, 15 and 16. Various embodiments are defined in the dependent claims.

In the present invention alternative laser structures, apparatus or devices, which have potentially the same tuning performance as (S)SG-DBR and GCSR lasers and which output power does not pass through a long passive region, are presented.

An integrated/semiconductor tunable laser comprising a substrate made of a semiconducting material, a two-sided active section on said substrate, and a plurality of sections on said substrate, is disclosed. Said laser can be denoted as a multi-section integrated semiconductor laser. Said active section is radiation generating, for instance, but not limited to the range of optical radiation. All said sections are connected to one side of said active section. Note that this does not mean that they are directly coupled to said active section. In case of optical radiation said connection can be denoted as an optical connection. At least two of said sections include a waveguide system. Each of said sections defines a resonator.

These resonator sections have a spectra with spaced maxima resonation points themselves. They are themselves either a filter or a reflector with a comb mode spectra.

The resonators used in the present invention have resonation characteristics with a plurality of resonation peaks. Alternatively it can be said that said resonators have spaced resonation maxima points providing a maximum resonance of an associated wavelength. The transmission filters used in the present invention have a transmission characteristic with a plurality of transmission peaks. Alternatively it can be said that said transmission filters have spaced transmission maxima points providing a maximum transmission of an associated wavelength. The reflectors used in the present invention have a reflection characteristic with a plurality of reflection peaks. Alternatively it can be said that said reflectors have spaced reflective maxima points providing a maximum reflection of an associated wavelength.

The spacing of said resonator maxima points corresponding to the transmission or reflective maxima points of at least two of said sections are selected to be essentially not equal or different. Said laser is therefore denoted as an integrated semiconductor laser with different reflection or transmission sections. The transmission and reflection characteristic of said transmission filters and reflectors are positioned relative to each other such that at least one said transmission or reflective maxima of each of said two sections being overlapping each other. This means that said sections have at least one transmission or reflective maxima for a same first frequency. Due to the different spacings of said transmission or reflective maxima points a small shift of one of said transmission or reflective characteristics can result in overlapping of at least one other transmission or reflective maxima of each of said two sections. Said sections have then at least one second frequency in common, which can be largely different from said first frequency. Said shift can be due to current injections in said transmission or reflective sections. It can be said that said laser comprises means for injecting current into some of said plurality of sections, resulting in said transmission or reflection characteristic being shifted in wavelength. Said overlapping maxima points define a plurality of lasing wavelengths. Due to the small shifting of at least one resonator characteristic, said device jumps from a first set of lasing wavelengths to another set of lasing wavelengths. The spacings of the maxima resonation points are accordingly essentially determined by the grating instead of the length of the sections.

It can be said that said active section creates a radiation or a lightbeam by emission and that the device emits an emitted laser beam with the wavelength of said emitted lightbeam being in correspondence with said overlapping maxima of said transmission filters or reflectors. Said active section is thus creating radiation or a light beam by spontaneous emission over a bandwidth around a center frequency and guides said radiation or light beam and has (optical) amplification actions. Said emitted radiation or lightbeam does not pass through said plurality of sections. The combination of said plurality of sections, having a combinated reflection action, and said (optical) amplification action of said active section causes lasing at said set of lasing wavelengths. Due to the fact that small shifting of resonator characteristics results in large difference in the set of lasing wavelenghts, an optical laser having a wide tunability, is obtained. Said laser is therefore denoted widely wavelength tunable integrated semiconductor laser.

According to a preferred embodiment of the present invention, the active radiation-generating section is connected at one side to a plurality of grated sections, but said gratings are not included in said active section. Moreover the gratings are selected such that substantial interaction between the spectra of said gratings can be used because this is the working principle used for improving the selectivity. Therefore at least one of said resonation maxima of each of two said sections are overlapping with each other.

In an embodiment of the invention only one of said resonator maxima points is overlapping. It can then be said that said active section creates a radiation or a lightbeam by emission and the device emits an emitted laser beam with the wavelength of said emitted lightbeam being in correspondence with said overlapping maxima of said transmission filters or reflectors. The combination of said plurality of sections, having a combinated reflection action with a single reflection wavelength, and said (optical) amplification action of said active section causes lasing at said single reflection wavelength, defined by said overlapping resonator maxima points.

In an embodiment of the invention at least one of said plurality of sections is inactive. This means that such inactive section is not creating a lightbeam by emission.

In an embodiment of the invention at least one of said plurality of sections is active. This means that such active section also creates a lightbeam by emission.

In an embodiment of the invention at least one of said waveguide systems has a periodically broken short-period structure including short period stripped regions alternating with non-stripped regions. Such waveguide systems are also denoted distributed, hence said laser is denoted a semiconductor laser with distributed reflection or transmission sections. In the invention two such waveguides can be found on the same side of the active region.

In an embodiment of the invention at least one of said waveguide systems has a diffractive grating having a plurality of repeating unit regions each having a constant length, thus forming a modulation period, and at least one parameter that determines the optical reflectivity or transmission of said diffractive grating varying depending on its position in each of said repeating unit regions along a direction of optical transmission in said laser, said diffractive grating extending by at least two modulation periods.

In an embodiment of the invention at least one of said waveguide systems is a ring resonator.

In an embodiment of the invention the laser comprises further of a plurality of power splitters, being exploited for optically connecting part of said plurality of sections and connecting part of said plurality of sections with said active section.

In an embodiment of the invention said laser is a serial concatenation of said active section and a plurality of said sections.

In an embodiment of the invention said laser is a connection of said active section to one single port side of a power splitter and a parallel connection of a plurality of sections to the other multi port side of said power splitter.

In an embodiment of the invention said laser comprises phase sections, being exploiting for adjusting the round trip cavity phase and thus a lasing mode wavelength of the laser.

### Brief description of the invention

Fig. 1 is a longitudinal cross-section of an SG-DBR laser. As opposed to a conventional DBR laser, the reflectors are formed by two periodically modulated (sampled) gratings with different sampling periods.

Fig. 2 is a schematic diagram of a GCSR laser structure.

Fig. 3 is a top view (schematic) of the proposed "Y-SSG" laser.

Fig. 4 is a schematic view of a ring resonator (S)SG laser.

Fig. 5 is a transmission characteristic of a ring resonator.

Fig. 6 is a principle scheme of the laser according to the inevntion, comprising an active element and a plurality of sections, being either transmission filters or reflectors.

Fig. 7 is a principle scheme of prior-art lasers, comprising an active element and reflectors, said active element being bounded by said reflectors.

Fig. 8 is a principle scheme of the second embodiment of the invention, comprising an active element and a plurality of sections, being parallel.

Fig. 9 is a principle scheme of the fourth embodiment of the invention, comprising an active element and a serial concatenation of transmission filters ended by a reflector.

### Detailed description of the invention

In the further description several embodiments of the invention are presented. It must be clear that the scope of the invention is described by the claims.

The present invention discloses alternative laser structures, which ahe potentially the same tuning performance as (S)SG-DBR and GCSR lasers and which the output power does not pass through a long passive region. In said devices there are passive or inactive regions on one side of the active region only.

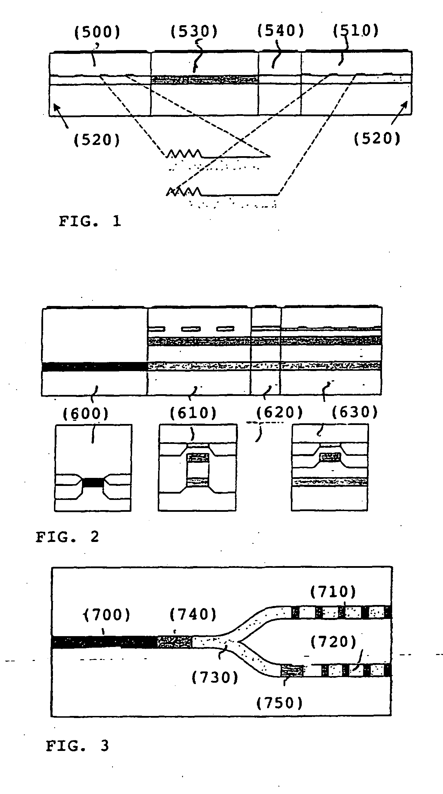

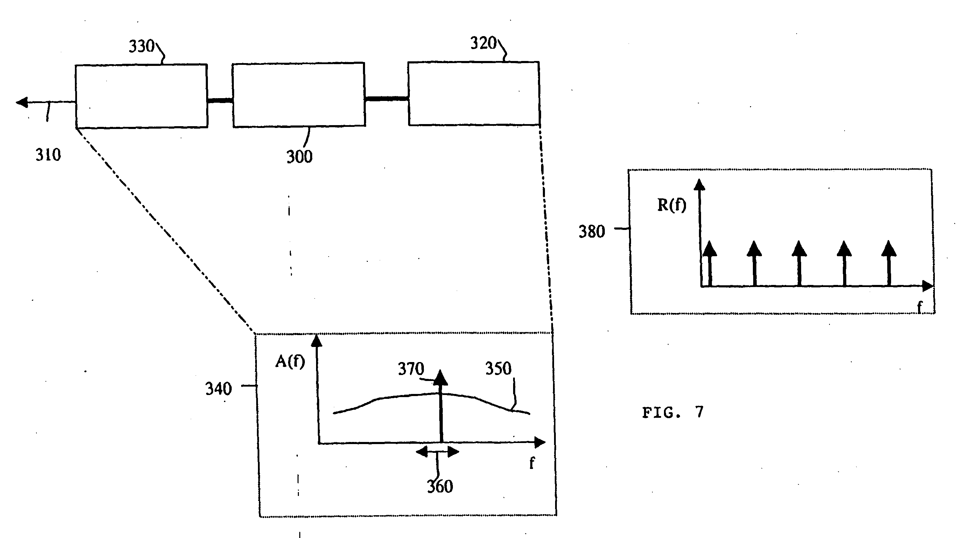

A principle scheme of prior-art conventional Distributed Bragg Reflector (DBR) semiconductor laser is shown in Figure 7. A schematic description of such a laser is shown in Figure 1, showing a front (500) reflector, a rear reflector (510), an AR (anti-reflective coating), an active section (530) and a phase section (540). Tuning of said laser is limited by the fact that the relative tuning range (360) is restricted to the relative change in the refractive index of the tuning region. This means that the tuning range, under normal operating conditions, cannot exceed 10 nm. This is substantially less than the potential bandwidth, restricted by the width of the gain curve (350), which is about 100 nm. Such conventional DBR lasers can functionally be characterized as comprising a first part being a two-sided active section (300), for creating a light beam (310) by spontaneous emission over a bandwidth around some center frequency (370), as observed in said lasers characteristic (340). Said first part also guides said light beam. Such conventional DBR lasers further have two reflectors (330)(320). Said reflectors are bounding said two-sided active section (300), thus one at each side.

A classical laser structure comprises (i) a two-sided active section/region, creating a light beam by spontaneous emission over a bandwidth around some center frequency and guiding said light beam, said active section performing optical amplification actions and (ii) two (inactive or passive) sections/regions, acting as reflectors. Said active section is bounded by said two reflectors.

Besides (inactive or passive) reflecting sections/regions, also sections with a transmission characteristic exist.

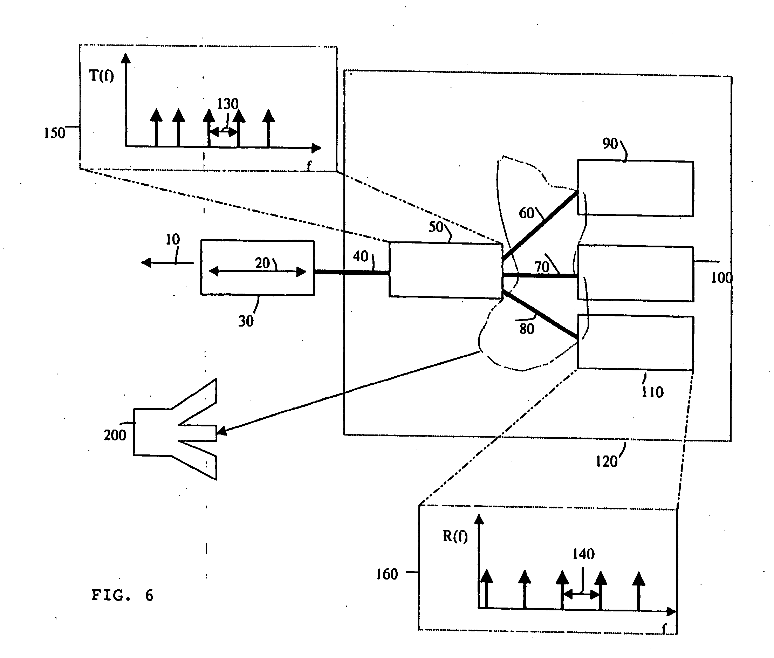

The invention can be characterized as comprising a two-sided active section/region (just as a classical laser) and a plurality of sections/regions. Said plurality of sections/regions defines a network of sections/regions. Said network of sections/regions is connected to one side of the active region. Said network comprises at least two resonator regions/sections. Said resonator regions/section can be either reflectors and regions/sections with a transmission characteristic. The principle scheme of the laser according to the invention, comprising an active element (30) and a plurality of sections (50) (90) (100) (110), being resonators, thus being either transmission filters or reflectors, is shown in Figure 6.

The invention can be characterized as a device comprising (i) a substrate made of a semiconducting material, (ii) a two-sided active section on said substrate, said active section generating radiation by spontaneous emission over a bandwidth around some center frequency and guiding said radiation, said active section having amplification actions, and (iii) a plurality of sections on said substrate, all said sections being connected to one side of said active section, at least two of said sections including a waveguide system, defining either a transmission filter or a reflector. The device can further be comprising a plurality of power splitters, being exploited for interconnecting part of said inactive sections and connecting part of said sections with said active section. Said sections can be either active or inactive.

When said device creates a light beam, said connection of said network with said active section is an optical connection. Said connections of said sections are then also optical. Said device can then be denoted as a tunable integrated/semiconductor optical laser. Said amplification is then denoted to be an optical amplification. Said active section then also guides said light beam.

In the invention particular reflectors and sections with transmission characteristics are exploited. Said reflectors and sections with transmission characteristics are commonly denoted as resonators. Said reflection and transmission sections are functionally characterized as having a reflection or transmission characteristic with a plurality of reflection or transmission peaks, commonly denoted as resonation peaks. Said reflection or transmission characteristic has spaced reflection or transmission maxima points providing a maximum reflection or transmission of an associated wavelength. The resonator characteristic thus has a plurality of spectral response peaks, preferably narrow spectral response peaks. Said resonator characteristic can be either regular, meaning that its resonation frequencies are all spaced apart by a same value, being the periodicity, or irregular, meaning that there is no fixed spacing between its resonation frequencies. Irregularity can be a random pattern of resonation frequencies or some structured pattern.

Such a characteristic can be obtained via sampled gratings, which exhibit a comb-shaped reflection or transmission spectrum or via the so-called supergratings. Said gratings or supergratings can also be characterized as distributed reflectors or transmission sections.

Sampled gratings can be described as structures in a waveguide system, having a periodically broken short-period structure including short period stripped regions alternating with non-stripped regions. The supergratings can be described as structures in a waveguide system having a diffractive grating having a plurality of repeating unit regions each having a constant length, thus forming a modulation period, and at least one parameter that determines the optical reflectivity or transmission of said diffractive grating varying depending on its position in each of said repeating unit regions along a direction of optical transmission in said laser, said diffractive grating extending by at least two modulation periods.

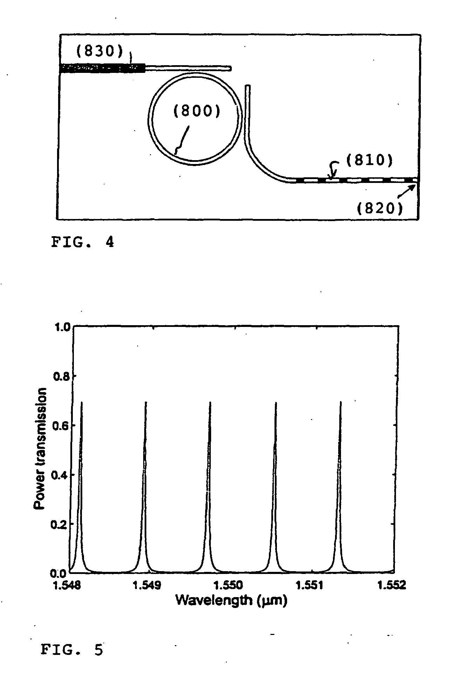

In the invention alternative sections with transmission characteristics based on ring resonators are exploited. Such a ring resonator has a comb-shaped transmission characteristic (Figure 5). The operation of a ring resonator is similar to that of a classic Fabry-Perot resonator, which can easily be understood if one thinks of the cross-coupling of the two couplers in the ring as being the transmission mirrors in the FP-resonator.

In the prior art constructive interference of the periodic characteristics of reflectors, located at different sides of the active section, with different periodicity is exploited to obtain a wide tunability. As the construction of said reflectors leads to long inactive sections, this results in lasing output power losses.

In the invention constructive interference of the periodic characteristics of sections, being either reflective or transmissive, and with different periodicity and located at the same side of the active section is exploited. This approach results in wide tunability of said laser. Even when said reflectors are by construction long inactive sections, this is not harmful for the lasing output power, as these are only located at a single side of the active section. The invention results in a low loss window at any time.

Thus the invention can be further characterized by stating that the spacing of at least two transmission or reflective maxima points of the respective (inactive or even active) sections being essentially not equal or different, and at least one said transmission or reflective maxima of each of said (inactive or even active) sections being in correspondence with a wavelength of said created lightbeam. This correspondence is obtained by having at least one of said resonation peaks of at least two sections being overlapping or coinciding.

The combination of said plurality of sections can be considered as a combined reflector, having a combination reflection action. Said optical amplification action of said active section and said combination reflection action of said combined reflector are causing lasing at least one of the reflection wavelengths of said combined reflector.

Figure 6 shows an example of a possible configuration although the invention is not limited hereto. The active section (30) is optically at one side connected with a plurality of sections (120), said plurality of sections comprising a transmission filter (50) and three reflectors (90)(100)(110). The lasing light (10) leaves the laser at the other side of the active section. (20) indicates the amplification action within said active section (10). Said connections (40), (60), (70) and (80) indicate the optical interconnectivity and should not be considered as physical connections.

The transmission filters exploited in the invention have a transmission characteristic (150) with a plurality of transmission peaks. Alternatively it can be said that said transmission filters have spaced (spacing (130)) transmission maxima points providing a maximum transmission of an associated wavelength. The reflectors exploited in the invention have reflection characteristic (160) with a plurality of reflection peaks. Alternatively it can be said that said reflectors have spaced (spacing period (140)) reflective maxima points providing a maximum reflection of an associated wavelength. The spacing (130) (140) of said transmission or reflective maxima points of at least two of said sections are selected to be different. Said laser is therefore denoted an integrated semiconductor laser with different reflection or transmission sections. The transmission and reflection characteristic of said transmission filters and reflectors are positioned such that only one said transmission or reflective maxima of each of said sections being overlapping, meaning having a transmission or reflective maxima for the same frequency. Due to the different spacings of said transmission or reflective maxima points a small shift of one of said transmission or reflective maxima points results in an optical laser having a wide tunability. Said laser is therefore denoted widely wavelength tunable integrated semiconductor laser. Said shift can be due to current injections in said transmission or reflective sections. It can be said that said laser comprises of means for injecting current into part of said plurality of sections, resulting in said transmission or reflection characteristic being shifted in wavelength.

The configuration of Figure 6 can for instance be achieved by using a power splitter (200) for connecting section (50) with sections (90)(100)(110). Said power splitter has a single port side (side connected to (50)) and a multi port side (side connected to (90)(100)(110), with three ports.

A schematic view of a prior art GCSR laser structure is shown in Figure 2, showing an active section (600), a coupler section (610), a phase section (620), and a reflector (630), and the cross sections of said sections. Said coupler section and said reflector section have an essentially different resonance characteristic. Said coupler section does not have spaced resonation maxima points.

In a first embodiment a Y-structure as in Figure 3 is proposed with two reflectors (710), (720), placed on the same side of the active region (700). These two reflectors use sampled or super structure gratings to provide reflection combs with different periods; their design is the same as for (S)SG-DBR lasers. The power splitter (730) is used to split/combine the light leaving/entering the active region. Two phase control sections (740), (750) are shown in Figure 3. One provides the correct phase relation between the signals reflected by the two reflectors, whereas the second provides control of the overall phase of the combined reflected signal. According to an alternative embodiment, a separate phase control section could be placed in each of the arms of the Y. The branches of the Y-structure could be all-active, thus avoiding a (technologically more complex) transition from an active waveguide to a passive one. However, this has the disadvantage that the device will be more difficult to control, because power and wavelength control will be mixed. Therefore, passive waveguides for both branches of the Y-structure are preferred.

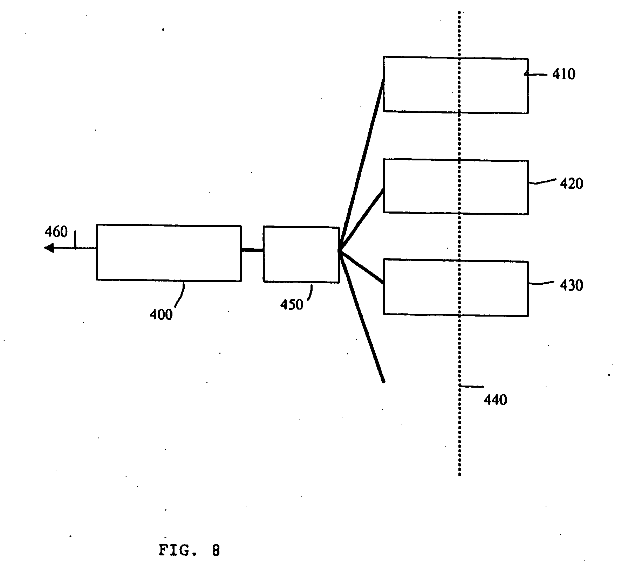

In a second embodiment a second structure, which in a top view looks like in Figure 8, is proposed. In this structure a plurality of reflectors (440) (including reflectors (410, 420, 430) are placed on the same side of the active region. At least two of said reflectors use sampled or super structure gratings to provide reflections combs. At least two of said reflectors have reflection combs with different periods. The design of said reflectors is the same as for (S)SG-DBR lasers. The power splitter (450) is used to split and combine the light leaving/entering the active region. Phase control sections can be introduced. In one configuration one phase control section is placed between the active region and the reflectors and in all reflectors, except one, also a phase control section is provided. In another configuration only phase control sections are provided in said reflectors.

In a third embodiment a third structure, as shown in Figure 4, is proposed. The reflector consists of an active section (830), a ring resonator (800), which has a comb-shaped transmission characteristic (Figure 5) and a (S)SG-reflector (810) with potentially even an anti-reflective coating (820). The operation of a ring resonator is similar to that of a classic Fabry-Perot resonator, which can easily be understood if one thinks of the cross-coupling of the two couplers in the ring as being the transmission mirrors in the FP-resonator. The tuning is again based on the "Vernier"-principle, as in conventional (S)SG-DBR lasers: the ring resonator and the (S)SG-reflector are designed to have slightly different peak-spacing in their transmission and reflection characteristics respectively, and lasing occurs at or near the wavelength where two peaks overlap each other. A phase section, used to align a longitudinal cavity mode with the two aligned peaks, could also be included in this structure. It could be placed either between the active section and the ring resonator, or between the ring and the (S)SG-reflector.

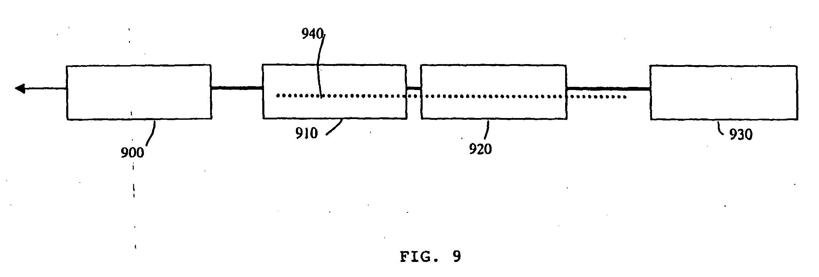

In a fourth embodiment a fourth structure, as shown in Figure 9, is proposed. This structure comprises an active region (900) bounded at one side by a serial concatenation of sections, being a plurality of transmission filters (940), including filters (910) (920), said concatenation ends with a reflector (930). At least two of said sections, being either transmission filter or reflector, have a comb-shaped transmission characteristic. At least two of said sections, being either transmission filter or reflector, are designed to have a slightly different peak-spacing in their characteristic. A phase section can be placed between any of said sections and between said active section and said sections. Said transmission filters can be either (S)SG-transmission filters or a ring-resonator. Said reflector is a (S)SG-reflector.

A main feature of the proposed Y and ring-structures and any structure, exploiting a combination of the principles on which the proposed Y and ring structures are based, is that light is emitted directly from the active region without going through a passive region. This is expected to result in a higher efficiency and a lower degree of power variation during tuning. Typical reflectors can be designed to have a uniform envelope of the reflection peaks. These designs require long passive waveguides and the reflectivity at the reflection peaks is quite high. Both of these factors lead to a reduced efficiency in a two-sided reflector structure. In all proposed structures the output power is not passing through a reflector, hence a high efficiency can be expected, and the high reflectivity is now an advantage. Therefore in the invention all said sections are optically connected to one side of said active region.

Since the reflectors are preferably passive, the Y structure (of the first embodiment) and the structure of the second embodiment, does not suffer from the control problems present in the Y-laser, known from prior-art.

The performance with respect to tuning and output power is expected to be similar to that of a GCSR laser, but the fabrication is easier. The number of process steps will be the same as for an SG/SSG, but lower than for a GCSR laser. Except for mask design the fabrication is nearly identical to that for SG/SSG DBR lasers, but AR coating of the facets may not be necessary when the grating is designed for high peak reflectivity. As an alternative one could use an absorbing region to kill off any unwanted reflection from the facet.

There may be some radiation losses associated with the power splitter in the Y-laser, but these are unlikely to be higher than the radiation losses in the tunable coupler section of the GCSR.

## Claims

1. An integrated semiconductor laser apparatus comprising
- a substrate made of a semiconducting material,
- a two-sided active radiation-generating section (30) on said substrate,
- a plurality of sections not used for generating radiation on said substrate (120), said plurality of sections being optically connected to one side surface of said two-sided active section, all said sections being connected together, each of at least two of said sections includes a waveguide system and has spaced resonation maxima points providing a maximum resonance with an associated wavelength, whereby the spacing of at least two of said resonation maxima points of the respective sections is not equal, whereby said at least two sections are either a transmission filter and a reflector coupled in series or two reflectors coupled in parallel, and
- further comprising means for injecting current into at least some of said two sections such that said spaced resonation maxima points are shifted in wavelength so that at least one of said resonation maxima of each of two said sections overlap each other, **characterised in that** said at least two of said sections are resonators.

2. The apparatus as recited in claim 1, further comprising at least one phase section.

3. The apparatus as recited in claim 2, wherein a phase section is placed between the radiation-generating section (30) and said plurality of sections (120).

4. The apparatus as recited in claim 3, further comprising a further phase section placed in said plurality of sections.

5. The apparatus according to any one of the preceding claims, further comprising a plurality of phase sections, being used for adjusting the round trip cavity phase.

6. The apparatus as recited in any one of the preceding claims, wherein at least one of said sections has an anti-reflective coating on its facets.

7. The apparatus as recited in any one of the preceding claims, wherein at least one of said sections has no anti-reflective coating on its facets.

8. The apparatus as recited in any one of the preceding claims, wherein said reflectors are designed in order to have a uniform envelope of the reflection peaks.

9. The apparatus as recited in any one of the preceding claims, wherein only one of said resonation maxima of each of said sections being resonators overlapping each other.

10. The apparatus as recited in any one of the preceding claims, wherein either said transmission filter (50), has spaced transmission maxima points (130) providing a maximum transmission with an associated wavelength as resonation maxima points or said reflector (90), (100), (110), has spaced reflective maxima points (140) providing a maximum reflection with an associated wavelength as resonation maxima points.

11. The apparatus according to any one of the preceding claims, wherein at least one of said plurality of sections is inactive.

12. The apparatus according to any one of the preceding claims, wherein at least one of said plurality of sections is active.

13. The apparatus according to any one of the preceding claims, wherein at least one of said waveguide systems has a periodically broken short-period structure including short period stripped regions alternating with non-stripped regions.

14. The apparatus according to any one of the preceding claims, wherein at least one of said resonators has irregular resonation maxima.

15. The apparatus according to any one of the preceding claims 1 to 14, wherein at least one of said waveguide systems has a diffractive grating having a plurality of repeating unit regions each having a constant length, thus forming a modulation period, and at least one parameter that determines the optical reflectivity or transmission of said diffractive grating varying depending on its position in each of said repeating unit regions along a direction of optical transmission in said laser, said diffractive grating extending by at least two modulation periods.

16. The apparatus according to any one of the preceding claims, wherein at least one of said resonators has regular resonation maxima.

17. The apparatus according to any one of the preceding claims 1 to 12, wherein at least one of said waveguide systems is a ring resonator (800).

18. The apparatus according to any one of the preceding claims 11 to 16, wherein said active section is creating a light beam by spontaneous emission over a bandwidth around one center frequency and guiding said light beam and having optical amplification actions.

19. The apparatus as recited in claim 18, wherein the combination of said plurality of sections has a combinated reflection action and said optical amplification action of said active section causing lasing at at least one of the reflection wavelengths of said combination.

20. The apparatus as recited in any one of the preceding claims, wherein the combination of said plurality sections having a combinated reflection action and said optical amplification action of said active sections is arranged in order to cause lasing at said resonation maxima.

21. The apparatus according to any one of the preceding claims 11 to 20, further comprising a plurality of power splitters (200), being used for connecting some of said plurality of sections and connecting to said active section.

22. The apparatus as recited in claim 12 to 21, wherein said apparatus is a serial concatenation of said active section (900) and a plurality of said sections (910), (920), (930).

23. The apparatus as recited in claim 21, wherein a connection of said active section (400) is performed to one single port side of a power splitter (450) with a parallel connection of a plurality of sections (410), (420), (430) to the other multi port side of said power splitter.

24. A method for setting lasing frequencies of an integrated semiconductor laser apparatus, comprising a substrate made of semiconducting material, a two-sided active radiation-generating section on said substrate, a plurality of sections not used for generating radiation on said substrate, said plurality of sections being connected to one side surface of said two-sided active section, all said sections being connected together, whereby at least two of said sections have spaced resonation maxima points providing a maximum resonance with an associated wavelength, whereby the spacing of at least two of said resonation maxima points of the respective sections is equal, whereby said at least two sections are either a transmission filter and a reflector coupled in series or two reflectors coupled in parallel, said method comprising the step of positioning said resonation maxima points of said resonators such that a plurality of said resonation maxima of each of said sections being resonators overlap each other, said plurality defining said lasing frequencies, **characterized in that** said at least two of said sections are resonators.

25. A method for changing the lasing frequency of an integrated semiconductor laser apparatus as recited in claim 1 from a first frequency to a second frequency, said second frequency being spaced from said first frequency by a first distance, said integrated semiconductor laser apparatus comprising a substrate made of semiconducting material, a two-sided active radiation-generating section on said substrate, a plurality of sections on said substrate, said plurality of sections being connected to one side of said two-sided active section, all said sections being connected together, whereby at least two of said sections have spaced resonation maxima points providing a maximum resonance with an associated wavelength, wherein the spacing of at least two of said resonation maxima points of the respective sections is not equal, whereby said at least two sections are either a transmission filter and a reflector coupled in series or two reflectors coupled in parallel, said method comprising the step of changing the relative position of said resonation maxima points of said resonators with a second distance, being substantially smaller than said first distance, **characterized in that** said at least two of said sections are resonators.

## Patentansprüche

1. Integriertes Halbleiterlasergerät, Folgendes umfassend
- ein Substrat, hergestellt aus Halbleitermaterial,
- einen zweiseitigen aktiven strahlungserzeugenden Abschnitt (30) auf dem Substrat,
- mehrere Abschnitte, die nicht zum Erzeugen von Strahlung auf dem Substrat (120) verwendet werden, wobei die mehreren Abschnitte optisch mit einer Seitenfläche des zweiseitigen aktiven Abschnitts verbunden sind, wobei alle Abschnitte miteinander verbunden sind, wobei jeder der mindestens zwei der Abschnitte ein Wellenleitersystem aufweist und beabstandete Resonanzmaximalpunkte hat, die eine maximale Resonanz mit einer dazugehörenden Wellenlänge bereitstellen, wobei die Beabstandung von mindestens zwei der Resonanzmaximalpunkte der jeweiligen Abschnitte nicht gleich ist, wobei die mindestens zwei Abschnitte entweder ein Übertragungsfilter und ein Reflektor sind, die in Serie gekoppelt sind, oder zwei parallel geschaltete Reflektoren, und
- ferner umfassend Mittel zur Strominjektion in mindestens einige der zwei Abschnitte, so dass die beabstandeten Resonanzmaximalpunkte in der Wellenlänge derart verschoben werden, dass mindestens einer der Resonanzmaximalpunkte jedes der zwei Abschnitte einander überlappen, **dadurch gekennzeichnet, dass** die mindestens zwei der Abschnitte Resonatoren sind.

2. Gerät nach Anspruch 1, das ferner mindestens einen Phasenabschnitt aufweist.

3. Gerät nach Anspruch 2, wobei ein Phasenabschnitt zwischen dem strahlungserzeugenden Abschnitt (30) und den mehreren Abschnitten (120) platziert ist.

4. Gerät nach Anspruch 3, das ferner einen Phasenabschnitt aufweist, der in den mehreren Abschnitten platziert ist.

5. Gerät nach einem der vorhergehenden Ansprüche, das ferner mehrere Phasenabschnitte aufweist, die zum Einstellen der Umlaufhohlraumphase verwendet werden.

6. Gerät nach einem der vorhergehenden Ansprüche, wobei mindestens einer der Abschnitte eine Entspiegelungsbeschichtung auf seinen Facetten hat.

7. Gerät nach einem der vorhergehenden Ansprüche, wobei mindestens einer der Abschnitte keine Entspiegelungsbeschichtung auf seinen Facetten hat.

8. Gerät nach einem der vorhergehenden Ansprüche, wobei die Reflektoren konzipiert sind, um einen gleichförmigen Mantel der Reflexionsspitzen zu haben.

9. Gerät nach einem der vorhergehenden Ansprüche, wobei nur einer der Resonanzmaximalpunkte jedes der Abschnitte Resonatoren sind, die einander überlappen.

10. Gerät nach einem der vorhergehenden Ansprüche, wobei entweder das Übertragungsfilter (50) beabstandete Übertragungsmaximalpunkte (130) hat, die eine maximale Übertragung mit einer dazugehörenden Wellenlänge als Resonanzmaximalpunkte bereitstellen, oder der Reflektor (90), (100), (110) beabstandete Reflexionsmaximalpunkte (140) hat, die eine maximale Reflexion mit einer dazugehörenden Wellenlänge als Resonanzmaximalpunkte bereitstellen.

11. Gerät nach einem der vorhergehenden Ansprüche, wobei mindestens einer der mehreren Abschnitte inaktiv ist.

12. Gerät nach einem der vorhergehenden Ansprüche, wobei mindestens einer der mehreren Abschnitte aktiv ist.

13. Gerät nach einem der vorhergehenden Ansprüche, wobei mindestens eines der Wellenleitersysteme eine periodisch gebrochene Kurzperiodenstruktur hat, die Kurzperioden-gestrippte Bereiche hat, die mit nicht gestrippten Bereichen abwechseln.

14. Gerät nach einem der vorhergehenden Ansprüche, wobei mindestens einer der Resonatoren unregelmäßige Resonanzmaxima hat.

15. Gerät nach einem der vorhergehenden Ansprüche 1 bis 14, wobei mindestens eines der Wellenleitersysteme ein Beugungsgitter hat, das mehrere Wiederholungseinheitsbereiche hat, die jeweils eine konstante Länge haben und daher eine Modulationsperiode bilden, und mindestens einen Parameter, der das optische Reflexionsvermögen oder die Übertragung des Beugungsgitters variierend in Abhängigkeit von seiner Position in jedem der Wiederholungseinheitsbereiche entlang einer Richtung der optischen Übertragung in dem Laser bestimmt, wobei sich das Beugungsgitter um mindestens zwei Modulationsperioden erstreckt.

16. Gerät nach einem der vorhergehenden Ansprüche, wobei mindestens einer der Resonatoren regelmäßige Resonanzmaxima hat.

17. Gerät nach einem der vorhergehenden Ansprüche 1 bis 12, wobei mindestens eines der Wellenleitersysteme ein Ringresonator (800) ist.

18. Gerät nach einem der vorhergehenden Ansprüche 11 bis 16, wobei der aktive Abschnitt einen Lichtstrahl durch spontanes Senden über eine Bandbreite um eine Mittenfrequenz schafft und den Lichtstrahl leitet und optische Verstärkungsaktionen hat.

19. Gerät nach Anspruch 18, wobei die Kombination der mehreren Abschnitte eine kombinierte Reflexionsaktion hat und wobei die optische Verstärkungswirkung des aktiven Abschnitts bei mindestens einer der Reflexionswellenlängen der Kombination Lasern bewirkt.

20. Gerät nach einem der vorhergehenden Ansprüche, wobei die Kombination der mehreren Abschnitte mit einer kombinierten Reflexionsaktion und optischen Verstärkungsaktion der aktiven Abschnitte derart angeordnet ist, dass Lasern an den Resonanzmaxima verursacht wird.

21. Gerät nach einem der vorhergehenden Ansprüche 11 bis 20, das ferner mehrere Leistungsteiler (200) aufweist, die zum Verbinden einiger der mehreren Abschnitte und Verbinden mit dem aktiven Abschnitt verwendet werden.

22. Gerät nach Anspruch 12 bis 21, wobei das Gerät eine Konkatenation in Serie des aktiven Abschnitts (900) und mehrerer der Abschnitte (910), (920), (930) ist.

23. Gerät nach Anspruch 21, wobei eine Verbindung des aktiven Abschnitts (400) mit einer einzelnen Schnittstellenseite eines Leistungsteilers (450) mit einer parallelen Verbindung mehrerer der Abschnitte (410), (420), (430) mit der anderen Multi-Schnittstellenseite des Leistungsteilers ausgeführt ist.

24. Verfahren zum Einstellen von Frequenzen zum Lasern eines integrierten Halbleiterlasergeräts, das ein Substrat bestehend aus Halbleitermaterial, einen zweitseitigen aktiven strahlungserzeugenden Abschnitt auf dem Substrat, mehrere Abschnitte, die nicht zum Erzeugen von Strahlung auf dem Substrat verwendet werden, aufweist, wobei die mehreren Abschnitte mit einer Seitenfläche des zweiseitigen aktiven Abschnitts verbunden sind, wobei alle Abschnitte miteinander verbunden sind, wobei mindestens zwei der Abschnitte beabstandete Resonanzmaximalpunkte haben, die eine maximale Resonanz bei einer dazugehörenden Wellenlänge bereitstellen, wobei die Beabstandung von mindestens zwei der Resonanzmaximalpunkte der jeweiligen Abschnitte gleich ist, wobei die mindestens zwei Abschnitte entweder ein Übertragungsfilter und ein Reflektor in Serie gekoppelt oder zwei Reflektoren parallel geschaltet sind, wobei das Verfahren den Schritt des Positionierens der Resonanzmaximalpunkte des Resonators derart aufweist, dass mehrere der Resonanzmaxima jedes der Abschnitte, die Resonatoren sind, einander überlappen, wobei diese mehreren mindestens zwei Laserungsfrequenzen definieren, **dadurch gekennzeichnet, dass** die mindestens zwei der Abschnitte Resonatoren sind.

25. Verfahren zum Wechseln der Laserungsfrequenz eines integrierten Halbleiterlasergeräts nach Anspruch 1 von einer ersten Frequenz zu einer zweiten Frequenz, wobei die zweite Frequenz von der ersten Frequenz durch einen ersten Abstand beabstandet ist, wobei das integrierte Halbleiterlasergerät ein Substrat bestehend aus Halbleitermaterial, einen zweiseitigen aktiven strahlungserzeugenden Abschnitt auf dem Substrat, mehrere Abschnitte auf dem Substrat aufweist, wobei die mehreren Abschnitte mit einer Seite des zweiseitigen aktiven Abschnitts verbunden sind, wobei alle Abschnitte miteinander verbunden sind, wobei mindestens zwei der Abschnitte beabstandete Resonanzmaximalpunkte haben, die eine maximale Resonanz bei einer dazugehörenden Wellenlänge bereitstellen, wobei die Beabstandung von mindestens zwei der Resonanzmaximalpunkte der jeweiligen Abschnitte nicht gleich ist, wobei die mindestens zwei Abschnitte entweder ein Übertragungsfilter und ein Reflektor in Serie gekoppelt oder zwei parallel geschaltete Reflektoren sind, wobei das Verfahren den Schritt des Änderns der relativen Position der Resonanzmaximalpunkte der Resonatoren mit einem zweiten Abstand aufweist, der im Wesentlichen kleiner ist als der erste Abstand, **dadurch gekennzeichnet, dass** mindestens zwei der Abschnitte Resonatoren sind.

## Revendications

1. Appareil laser semi-conducteur intégré comprenant
- un substrat constitué d'un matériau semi-conducteur,
- une section active générant un rayonnement des deux côtés (30) sur ledit substrat,
- une pluralité de sections non utilisée pour générer un rayonnement sur ledit substrat (120), ladite pluralité de sections étant optiquement connectée à une surface latérale de ladite section active des deux côtés, toutes lesdites sections étant connectées ensemble, chacune d'au moins deux desdites sections comprend un système de guide d'onde et comporte des points de maxima de résonance espacés fournissant une résonance maximale avec une longueur d'onde associée, moyennant quoi l'espacement d'au moins deux desdits points de maxima de résonance des sections respectives n'est pas égal, moyennant quoi lesdites au moins deux sections sont soit un filtre de transmission et un réflecteur couplés en série, soit deux réflecteurs couplés en parallèle, et
- comprenant en outre un moyen pour injecter du courant dans au moins certaines desdites deux sections de sorte que lesdits points de maxima de résonance espacés sont décalés en longueur d'onde de sorte qu'au moins un desdits maxima de résonance de chacune des deux sections chevauche les autres, **caractérisé en ce que** lesdites au moins deux sections sont des résonateurs.

2. Appareil selon la revendication 1, comprenant en outre au moins une section en phase.

3. Appareil selon la revendication 2, dans lequel une section en phase est placée entre la section générant un rayonnement (30) et ladite pluralité de sections (120).

4. Appareil selon la revendication 3, comprenant en outre une section en phase placée dans ladite pluralité de sections.

5. Appareil selon l'une quelconque des revendications précédentes, comprenant en outre une pluralité de sections de phase, qui sont utilisées pour ajuster la phase de cavité ronde.

6. Appareil selon l'une quelconque des revendications précédentes, dans lequel au moins une desdites sections comporte un revêtement anti-réfléchissant sur ses facettes.

7. Appareil selon l'une quelconque des revendications précédentes, dans lequel au moins une desdites sections ne comporte pas de revêtement anti-réfléchissant sur ses facettes.

8. Appareil selon l'une quelconque des revendications précédentes, dans lequel lesdits réflecteurs sont conçus afin d'avoir une enveloppe uniforme des pics de réflexion.

9. Appareil selon l'une quelconque des revendications précédentes, dans lequel seulement un des maxima de résonance de chacune desdites sections est un résonateur chevauchant l'autre.

10. Appareil selon l'une quelconque des revendications précédentes, dans lequel soit ledit filtre de transmission (50) présente des points de maxima de transmission espacés (130) fournissant une transmission maximale avec une longueur d'onde associée en tant que points de maxima de résonance, soit ledit réflecteur (90), (100), (110) présente des points de maxima réfléchissants espacés (140) fournissant une réflexion maximale avec une longueur d'onde associée en tant que points de maxima de résonance.

11. Appareil selon l'une quelconque des revendications précédentes, dans lequel au moins l'une de ladite pluralité de sections est inactive.

12. Appareil selon l'une quelconque des revendications précédentes, dans lequel au moins une de ladite pluralité de sections est active.

13. Appareil selon l'une quelconque des revendications précédentes, dans lequel au moins un desdits systèmes de guide d'onde présente une structure ayant une période courte interrompue périodiquement comprenant des régions dépouillées de période courte alternant avec des régions non dépouillées.

14. Appareil selon l'une quelconque des revendications précédentes, dans lequel au moins un desdits résonateurs comporte des maxima de résonance irréguliers.

15. Appareil selon l'une quelconque des revendications 1 à 14 précédentes, dans lequel au moins un desdits systèmes de guide d'onde comporte une grille de diffraction ayant une pluralité de régions de motif de répétition ayant chacun une longueur constante, formant ainsi une période de modulation, et au moins un paramètre qui détermine la réflectivité optique ou la transmission de ladite grille de déviation variant en fonction de sa position dans chacune desdites régions de motif de répétition le long d'une direction de transmission optique dans ledit laser, ladite grille de diffraction s'étendant par au moins deux périodes de modulation.

16. Appareil selon l'une quelconque des revendications précédentes, dans lequel au moins un desdits résonateurs présente des maxima de résonance réguliers.

17. Appareil selon l'une quelconque des revendications 1 à 12 précédentes, dans lequel au moins un desdits systèmes de guide d'onde est un résonateur de cycle (800).

18. Appareil selon l'une quelconque des revendications 11 à 16 précédentes, dans lequel ladite section active crée un faisceau lumineux par émission spontanée sur une bande passante autour d'une fréquence centrale et guide ledit faisceau lumineux et présente des actions d'amplification optique.

19. Appareil selon la revendication 18, dans lequel la combinaison de ladite pluralité de sections présente une action de réflexion combinée et ladite action d'amplification optique de ladite section active entraînant une émission laser à au moins l'une des longueurs d'onde de réflexion de ladite combinaison.

20. Appareil selon l'une quelconque des revendications précédentes, dans lequel la combinaison de ladite pluralité de sections présentant une action de réflexion combinée et ladite action d'amplification optique desdites sections actives est agencée afin d'entraîner une émission laser auxdits maxima de résonance.

21. Appareil selon l'une quelconque des revendications 11 à 20 précédentes, comprenant en outre une pluralité de diviseurs de puissance (200), qui sont utilisés pour connecter certaines de ladite pluralité de sections et être connectés à ladite section active.

22. Appareil selon les revendications 12 à 21, dans lequel ledit appareil est une concaténation en série de ladite section active (900) et une pluralité desdites sections (910), (920), (930).

23. Appareil selon la revendication 21, dans lequel une connexion de ladite section active (400) est effectuée à un côté à port unique d'un diviseur de puissance (450) avec une connexion parallèle d'une pluralité de sections (410), (420), (430) à l'autre côté à port multiple dudit diviseur de puissance.

24. Procédé destiné à fixer des fréquences d'émission laser d'un appareil laser semi-conducteur intégré, comprenant un substrat constitué d'un matériau semi-conducteur, une section active générant un rayonnement des deux côtés sur ledit substrat, une pluralité de sections non utilisées pour générer un rayonnement sur ledit substrat, ladite pluralité de sections étant connectée à une face latérale de ladite section active des deux côtés, toutes lesdites sections étant connectées ensemble, moyennant quoi au moins deux desdites sections ont des points de maxima de résonance espacés fournissant une résonance maximale avec une longueur d'onde associée, moyennant quoi l'espacement d'au moins deux desdits points de maxima de résonance des sections respectives est égal, moyennant quoi lesdites au moins deux sections sont soit un filtre de transmission et un réflecteur couplés en séries, soit deux réflecteurs couplés en parallèle, ledit procédé comprenant l'étape consistant à positionner lesdits points de maxima de résonance desdits résonateurs de sorte qu'une pluralité desdits maxima de résonance de chacune desdites sections soit des résonateurs qui se chevauchent les uns les autres, ladite pluralité définissant lesdites fréquences d'émission laser, **caractérisé en ce que** lesdites au moins deux desdites sections sont des résonateurs.

25. Procédé destiné à modifier la fréquence d'émission laser d'un appareil laser semi-conducteur intégré selon la revendication 1, à partir d'une première fréquence vers une seconde fréquence, ladite seconde fréquence étant espacée de ladite première fréquence d'une première distance, ledit appareil laser semi-conducteur intégré comprenant un substrat constitué d'un matériau semi-conducteur, une section active générant un rayonnement des deux côtés sur ledit substrat, une pluralité de sections sur ledit substrat, ladite pluralité de sections étant connectée à un côté de ladite section active des deux côtés, toutes lesdites sections étant connectées ensemble, moyennant quoi au moins deux desdites sections ont des points de maxima de résonance espacés fournissant une résonance maximale avec une longueur d'onde associée, dans lequel l'espacement d'au moins deux desdits points de maxima de résonance des sections respectives n'est pas égal, moyennant quoi lesdites au moins deux sections sont soit un filtre de transmission et un réflecteur couplés en série, soit deux réflecteurs couplés en parallèle, ledit procédé comprenant l'étape consistant à modifier la position relative desdits points de maxima de résonance desdits résonateurs avec une seconde distance, qui est sensiblement plus petite que ladite première distance, **caractérisé en ce que** lesdites au moins deux desdites sections sont des résonateurs.
